# EUROPÄISCHE PATENTSCHRIFT

(11) **EP 3 708 841 B1**
(45) Veröffentlichungstag und Bekanntmachung des Hinweises auf die Patenterteilung: **24.08.2022**
(21) Anmeldenummer: 19162214.1
(22) Anmeldetag: 12.03.2019
(51) Int. Cl.: F04D 19/00, F04D 29/54, F04D 29/58, H01L 23/467

(54) **VORRICHTUNG ZUM KÜHLEN WÄRMEABSTRAHLENDER BAUTEILE**
DEVICE FOR COOLING HEAT-RADIATING COMPONENTS
DISPOSITIF DE REFROIDISSEMENT DE COMPOSANTS RAYONNANT DE LA CHALEUR

(43) Veröffentlichungstag der Anmeldung: 16.09.2020
(73) Patentinhaber: VITRONIC Dr.-Ing. Stein Bildverarbeitungssysteme GmbH, 65189 Wiesbaden (DE)
(72) Erfinder: SIBER, Ralf, 55118 Mainz (DE)
(74) Vertreter: Neumann Müller Oberwalleney Patentanwälte PartG mbB

(56) Entgegenhaltungen:
- EP-A1- 2 051 299
- US-A1- 2003 007 867
- US-B2- 7 018 175

## Beschreibung

Die Erfindung betrifft eine Vorrichtung zum Kühlen wärmeabstrahlender Bauteile gemäß dem Oberbegriff des Anspruchs 1.

Vorrichtungen zum Kühlen wärmeabstrahlender Bauteile sind in verschiedenen Ausführungsformen bekannt. Sie dienen zum Abführen von Verlustwärme, vorzugsweise elektronischer Komponenten, um deren Beschädigung oder Ausfall aufgrund zu hoher Temperaturen zu vermeiden. Der Wärmeübergang von den wärmeabstrahlenden Bauteilen zur Umgebungsluft ist hierbei von der Temperaturdifferenz, der wirksamen Oberfläche des Kühlkörpers und der Strömungsgeschwindigkeit zwischen der Luft und dem Kühlkörper abhängig. Kühlkörper weisen daher üblicherweise eine Vielzahl von Kühlrippen auf, um die wirksame Oberfläche des Kühlkörpers zur Umgebungsluft möglichst groß zu gestalten. Der Axiallüfter dient dazu, die Strömungsgeschwindigkeit zwischen der Luft und dem Kühlkörper zu erhöhen.

Die DE 10 2015 209 375 A1 zeigt eine Kühlvorrichtung mit einem Kühlkörper mit Kühlfinnen und einem Lüfter zum Fördern von Umgebungsluft über die Kühlfinnen. Der Kühlkörper weist eine Vertiefung auf, in welchem der Kühllüfter angeordnet ist. Der Kühllüfter ist als Axiallüfter ausgebildet, wobei angesaugte Umgebungsluft auf eine Grundplatte des Kühlkörpers auftrifft und so die Luft um 90 Grad umgelenkt und durch Zwischenräume zwischen den Kühlfinnen radial nach außen geführt wird. Die Kühlfinnen sind hierbei im Wesentlichen radial zu einer Lüfterachse, um die sich ein Lüfterrad des Lüfters dreht, angeordnet.

US 7 911 790 B2 beschreibt eine Kühlvorrichtung mit einem Kühlkörper, der radial von einem zylindrischen Kühlkörper vorstehende Kühlfinnen aufweist. Ein in axialer Richtung wirkender Axiallüfter fördert Umgebungsluft parallel zur Lüfterachse durch die Kühlfinnen.

Herkömmlich bekannt sind auch Kühlvorrichtungen mit Kühlkörpern, wobei die Kühlkörper eine ebene Grundplatte aufweisen, von der Kühlrippen vorstehen, die gerade und parallel zueinander entlang der Ebene der Grundplatte verlaufen. Ferner weisen diese bekannten Kühlvorrichtungen einen Axiallüfter auf, der ein Lüfterrad besitzt, welches um eine im rechten Winkel zur Ebene der Grundplatte angeordnete Lüfterachse drehend angetrieben ist, sodass Umgebungsluft in Richtung auf die Grundplatte gefördert wird. Die Grundplatte lenkt die Luft um 90 Grad um, sodass diese in zwei entgegengesetzten Richtungen seitlich vom Axiallüfter zwischen den Kühlrippen hindurch strömt.

Das Lüfterrad weist radial nach außen vorstehende Lüfterschaufeln auf, die die Kühlrippen überqueren. Durch die Drehbewegung der Lüfterschaufeln wird die Umgebungsluft entlang der Lüfterachse bewegt, wobei sich ein Drall um die Lüfterachse in Drehrichtung des Lüfterrades ergibt. Die geförderte Luft trifft somit in einem spitzen Winkel zu einer Ebene, die im rechten Winkel zur Lüfterachse steht, auf den Kühlkörper auf. In den Bereichen, in denen die Lüfterschaufeln eine Hauptbewegungsrichtung parallel zu den Kühlrippen aufweisen, wird die Umgebungsluft effizient in die Zwischenräume zwischen den Kühlkörpern gefördert, sodass in diesen Zwischenräumen eine hohe Strömungsgeschwindigkeit in Richtung der Hauptbewegungsrichtung der Lüfterschaufeln entsteht. In der entgegengesetzten Richtung entgegen der Hauptbewegungsrichtung der Lüfterschaufeln entsteht nur eine geringe Strömungsgeschwindigkeit.

In den Bereichen, in denen die Lüfterschaufeln eine Hauptbewegungsrichtung quer zu der Erstreckung der Kühlrippen aufweisen, wird die Luft weniger effizient in die Zwischenräume zwischen den Kühlrippen gefördert, sodass eine geringere Strömungsgeschwindigkeit erzielt wird.

Somit ergeben sich unterschiedliche Strömungsgeschwindigkeiten in den einzelnen Zwischenräumen zwischen den Kühlrippen, was bereichsweise zu einer weniger effizienten Kühlung der wärmeabgebenden Bauteile führt.

Eine eingangs beschriebene Kühlvorrichtung zeigt EP 2 051 299 A1. Die Kühlvorrichtung weist einen Kühlkörper mit einer ebenen Grundplatte auf, von der Kühlrippen vorstehen, die gerade und parallel zueinander entlang der Ebene der Grundplatte verlaufen. Ferner weist die Kühlvorrichtung einen Axiallüfter auf, der ein Lüfterrad besitzt, welches um eine im rechten Winkel zur Ebene der Grundplatte angeordnete Lüfterachse drehend angetrieben ist, sodass Umgebungsluft in Richtung zum Kühlkörper gefördert wird. Zwischen dem Axiallüfter und dem Kühlkörper ist ein Luftleitelement vorgesehen. Das Lüfterrad weist radial vorstehende Lüfterschaufeln auf, die, bezogen auf die Lüfterachse, in einer ersten Richtung geneigt sind. Das Luftleitelement weist radial zur Lüfterachse vorstehende Leitschaufeln auf, die entgegengesetzt der Lüfterschaufeln geneigt angeordnet sind.

Die Aufgabe der vorliegenden Erfindung ist es, bei einem Kühlkörper mit geraden und parallel zueinander angeordneten Kühlrippen eine effiziente Kühlung zu gewährleisten.

Die Aufgabe wird durch eine Vorrichtung zum Kühlen wärmeabstrahlender Bauteile gemäß Anspruch 1 gelöst.

Das Luftleitelement ermöglicht eine möglichst gleichmäßige Strömungsgeschwindigkeit in den einzelnen Zwischenräumen zwischen den Kühlrippen und ermöglicht somit eine effiziente Kühlung von wärmeabstrahlenden Bauteilen.

Der Axiallüfter weist ein Lüfterrad auf, das um die Lüfterachse drehend angetrieben ist, wobei das Lüfterrad mehrere quer zur Lüfterachse verlaufende Lüfterschaufeln aufweist. Hierbei kann ein herkömmlicher standardisierter Axiallüfter verwendet werden.

Das Luftleitelement ist in zwei Sektoren um die Lüfterachse mit Leitschaufeln besetzt, wobei in zwei weiteren Sektoren um die Lüfterachse das Luftleitelement frei von Leitschaufeln ist.

Hierbei gehen die mit Leitschaufeln besetzten Sektoren jeweils, auf radial äußere Enden der Leitschaufeln bezogen, von einem Anfangsradius bezogen auf die Lüfterachse aus, der einen spitzen Winkel mit den Kühlrippen einschließt, und verlaufen in Drehrichtung des Lüfterrades über einen Winkel von weniger als 180 Grad. Der Anfangsradius befindet sich somit in einem Bereich der Vorrichtung, in der die Lüfterschaufeln des Lüfterrades eine Hauptbewegungsrichtung aufweisen, die quer zur Längserstreckung der Kühlrippen verläuft. Damit die Luft möglichst effizient in die Zwischenräume zwischen den Kühlrippen eingeleitet wird, sind in diesem Bereich Leitschaufeln vorgesehen, die dazu dienen, den Luftstrom möglichst parallel zur Lüfterachse umzudenken.

Hierbei kann der Anfangsradius einen Winkel von weniger als 20° mit den Kühlrippen einschließen.

Die mit Leitschaufeln besetzten Sektoren können sich jeweils über einen Winkel von 80 bis 100 Grad erstrecken.

Das Luftleitelement kann mehrere quer zur Lüfterachse verlaufende Leitschaufeln aufweisen. Die Leitschaufeln können zumindest im Wesentlichen radial zur Lüfterachse angeordnet sein.

Die Leitschaufeln weisen jeweils, in Drehrichtung des Lüfterrades betrachtet, eine Leitschaufelvorderseite mit einer vorderen Leitfläche und eine Leitschaufelrückseite mit einer hinteren Leitfläche auf. Die Leitschaufeln dienen dazu, die Richtung der Luftströmung zu beeinflussen. Die Umgebungsluft, die von den Lüfterschaufeln des Lüfterrades gefördert wird, weist aufgrund der Drehbewegung des Lüfterrades einen Drall auf. Die Luftströmung entspricht daher einer Drallströmung, bei der die Luft in Richtung der Lüfterachse gefördert wird, jedoch einen Drall um die Lüfterachse aufweist und somit im Wesentlichen schraubenförmig bewegt wird. Um den Drall zu beeinflussen, dienen die Leitschaufeln des Luftleitelements, sodass zumindest bereichsweise über den Umfang um die Lüfterachse die Steigung der Drallströmung beeinflusst werden kann. Die vordere Leitfläche zumindest einer der Leitschaufeln kann konkav gewölbt ausgebildet sein.

Die vordere Leitfläche zumindest einer der Leitschaufeln kann zumindest bereichsweise einen spitzen Winkel mit einer Ebene einschließen, die die Lüfterachse beinhaltet. Somit kann eine Luftströmung, die einen Drall aufweist, derart umgelenkt werden, dass die Strömung in einem geringeren Winkel zur Lüfterachse oder parallel zu dieser verläuft.

Die hintere Leitfläche zumindest einer der Leitschaufeln kann konvex gewölbt ausgebildet sein. Die konvex gewölbte hintere Leitfläche kann hierbei zumindest annähernd parallel zu einer konkav gewölbten vorderen Leitfläche einer benachbarten Leitschaufel ausgebildet sein, sodass eine effiziente Umlenkung der Luftströmung zwischen zwei Leitschaufeln erzielt wird, ohne dass die Effizienz aufgrund eines schmaler werdenden Zwischenraum zwischen zwei benachbarten Leitschaufeln und damit einem erhöhten Gegendrucks reduziert wird.

In einer Ausgestaltung der Vorrichtung kann vorgesehen sein, dass die hintere Leitfläche zumindest einer der Leitschaufeln zumindest bereichsweise einen stumpfen Winkel mit einer Ebene einschließt, die rechtwinklig zur Lüfterachse angeordnet ist. Hierdurch wird die Luftströmung derart umgelenkt, dass sich ein erhöhter Drall ergibt, um zum Beispiel die Luftströmung mit einer höheren Strömungsgeschwindigkeit in einer Richtung parallel zu den Kühlrippen in die Zwischenräume der Kühlrippen leiten zu können.

Die in Drehrichtung des Lüfterrades betrachtet hintersten Leitschaufel eines Sektors kann derart gestaltet sein, dass sich dessen Dicke in Hauptströmungsrichtung um ein Vielfaches vergrößert. Somit weist die vordere Leitfläche einen anderen Winkel zur Lüfterachse auf, als die hintere Leitfläche. Die vordere Leitfläche kann zum Beispiel dazu dienen, den Luftstrom möglichst parallel zur Lüfterachse umzulenken, wobei die hintere Leitfläche derselben Leitschaufel dazu dient, den Luftstrom möglichst in eine Richtung quer zur Lüfterachse umzulenken.

Alle Leitschaufeln können derart angeordnet sein, dass deren vorderen Leitflächen jeweils zumindest eine der Kühlrippen queren. Somit wird das Umlenken der Luft in die Zwischenräume zwischen den Kühlrippen effizient gestaltet.

Der Axiallüfter und das Luftleitelement können in Richtung der Lüfterachse deckungsgleiche Außenkonturen aufweisen. Sie lassen sich somit zu einer baulichen Einheit mit kontinuierlicher Außenkontur zusammensetzen.

Das Luftleitelement kann einen Rahmen aufweisen, innerhalb dessen die Leitschaufeln angeordnet sind. Der Rahmen kann nach innen zur Lüfterachse weisende Innenflächen aufweisen, die zumindest bereichsweise einen Winkel von 40 bis 50 Grad zu einer Ebene aufweisen, die im rechten Winkel zur Lüfterachse angeordnet ist.

Ein Ausführungsbeispiel einer Vorrichtung zum Kühlen wärmeabstrahlender Bauteile wird im Folgenden anhand der Figuren näher erläutert. Hierin zeigen:
- Figur 1: eine perspektivische Ansicht der Vorrichtung gemäß der Erfindung,

- Figur 2: eine perspektivische Ansicht der Vorrichtung gemäß Figur 1, wobei der Axiallüfter gestrichelt dargestellt ist,
- Figur 3: eine perspektivische Explosionsdarstellung der Vorrichtung gemäß Figur 1,
- Figur 4: eine Seitenansicht des Kühlkörpers in Richtung der Längserstreckung der Kühlrippen mit schematischen Darstellung der Strömungsgeschwindigkeiten der Luft zwischen den Kühlrippen bei einer Vorrichtung gemäß Figur 1, jedoch ohne Luftleitelement,
- Figur 5: eine Seitenansicht des Kühlkörpers in Richtung der Längserstreckung der Kühlrippen mit schematischen Darstellung der Strömungsgeschwindigkeiten der Luft zwischen den Kühlrippen bei einer Vorrichtung gemäß Figur 1 mit Luftleitelement und
- Figur 6: einen Längsschnitt durch die Vorrichtung gemäß Figur 1 parallel zur Längsachse (entlang der Schnittlinie VI - VI gemäß Figur 5).

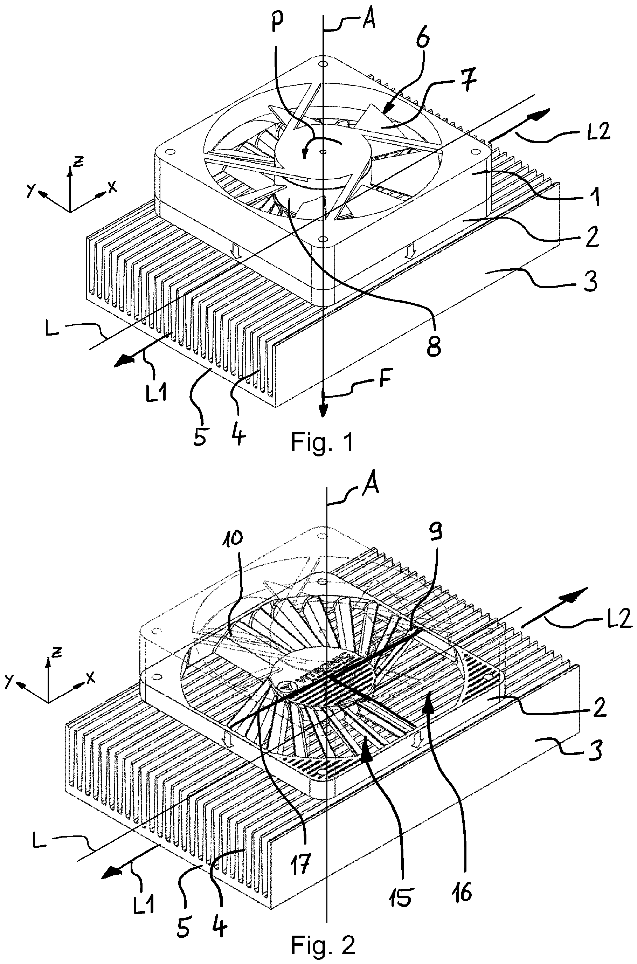

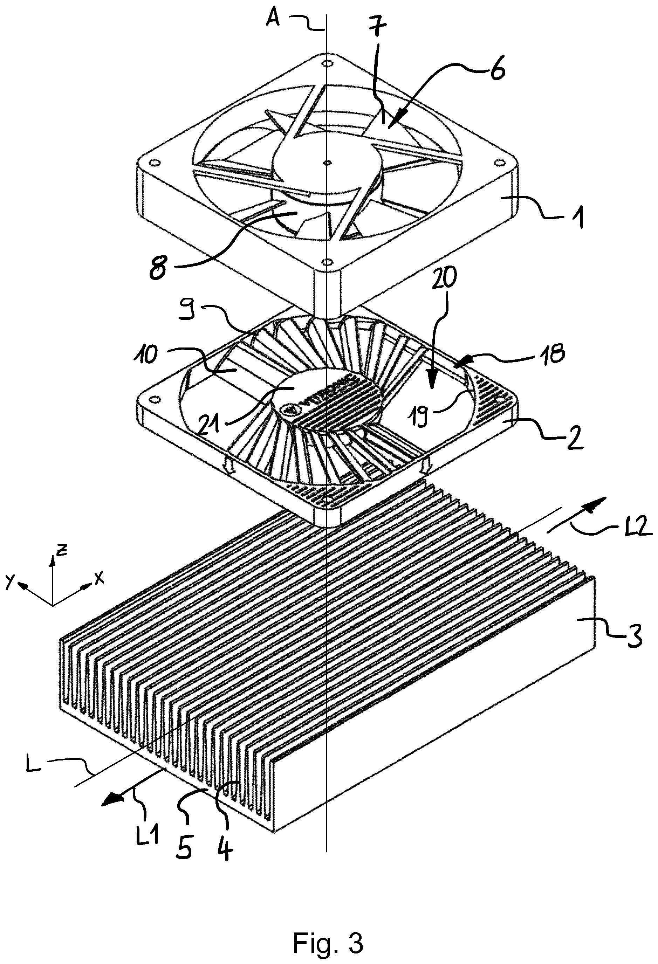

Die Figuren 1, 2 und 3 zeigen eine Vorrichtung zum Kühlen wärmeabstrahlender Bauteile, wobei der Übersichtlichkeit halber die wärmeabstrahlender Bauteile nicht dargestellt sind, in unterschiedlichen Ansichten und werden im Folgenden zusammen beschrieben.

Die Vorrichtung weist einen Axiallüfter 1, ein Luftleitelement 2 und einen Kühlkörper 3 mit Kühlrippen 4 auf. Der Axiallüfter 1 ist auf dem Kühlkörper 3 angeordnet, wobei sich das Luftleitelement 2 zwischen dem Axiallüfter 1 und dem Kühlkörper 3 befindet.

Der Kühlkörper 3 weist eine Grundplatte 5 auf, die eine Ebene bildet und von der die Kühlrippen 4 in Richtung zum Axiallüfter 1 vorstehen. Die Kühlrippen 4 erstrecken sich entlang einer Längsachse L, die parallel zur Ebene der Grundplatte 5 verläuft. Die Kühlrippen 4 sind gerade und parallel zueinander angeordnet. Die Längsachse L ist in Richtung einer X-Achse eines kartesischen Koordinatensystems angeordnet.

Der Axiallüfter 1 und das Luftleitelement 2 sind gegenüber der Grundplatte 5 auf den Kühlrippen 4 angeordnet, wobei der Axiallüfter 1 derart angeordnet ist, dass er Umgebungsluft angesaugt und entlang einer Lüfterachse A in Richtung zum Kühlkörper 3 und in Richtung zur Grundplatte 5 fördert. Die Lüfterachse A ist im rechten Winkel zur Längsachse L und im rechten Winkel der Ebene der Grundplatte 5 angeordnet und erstreckt sich in Richtung einer Z-Achse des kartesischen Koordinatensystems. Der Axiallüfter 1 fördert somit Umgebungsluft zwischen die Kühlrippen 4, wobei die Luft die Grundplatte 5 zwischen den einzelnen Kühlrippen 4 einströmt und um 90 Grad umgelenkt wird, sodass sich ein Luftstrom in einer ersten Ausströmrichtung L1 parallel zur Längsachse L und einer zweiten Ausströmrichtung L2 parallel zur Längsachse L ergibt. Die beiden Ausströmrichtung in L1 und L2 sind entgegengesetzt zueinander, sodass an den axialen Enden des Kühlkörpers 3 jeweils Luft parallel zur Längsachse L ausströmt.

Der Axiallüfter 1 und das Luftleitelement 2 haben die gleichen Abmessungen in Längsrichtung in Richtung der X-Achse und in Breitenrichtung in Richtung einer Y-Achse des kartesischen Koordinatensystems. Der Kühlkörper 3 weist in etwa dieselbe Breite in Breitenrichtung auf wie der Axiallüfter 1 und das Luftleitelement 2. Der Kühlkörper 3 ist jedoch in Längsrichtung (X-Achse) länger gestaltet als der Axiallüfter 1 und das Luftleitelement 2.

Der Axiallüfter 1 weist ein Lüfterrad 6 auf, das um die Lüfterachse A drehend angetrieben ist und mehrere quer zur Lüfterachse A verlaufende von einer Lüfternabe 8 vorstehende Lüfterschaufeln 7 aufweist. Das Lüfterrad 6 dreht sich hierbei in Richtung des Pfeils P gemäß Figur 1 und fördert die Luft in Richtung einer Hauptförderrichtung F gemäß Figur 1 parallel zur Lüfterachse A. Aufgrund der Drehbewegung des Lüfterrades 6 wird die angesaugten Luft in eine Drallströmung versetzt, wobei der Drall in Richtung der Drehrichtung des Lüfterrades 6 weist.

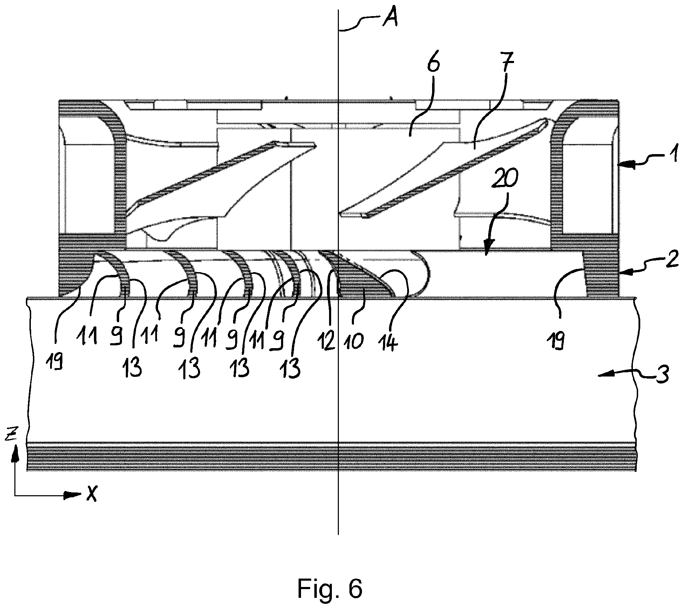

Das Luftleitelement 2 weist mehrere Leitschaufeln 9, 10 auf, die quer zur Lüfterachse A ausgerichtet sind. Die Leitschaufeln 9, 10 weisen jeweils, in Drehrichtung des Lüfterrades 6 betrachtet, eine Leitschaufelvorderseite mit einer vorderen Leitfläche 11, 12 und eine Leitschaufelrückseite mit einer hinteren Leitfläche 13, 14 auf. Im gezeigten Ausführungsbeispiel sind die vorderen Leitflächen 11, 12 im Querschnitt konkav gewölbt ausgebildet (siehe Figur 6). Die vorderen Leitflächen 11, 12 schließen im gezeigten Ausführungsbeispiel über ihre gesamte Höhe entlang der Lüfterachse A einen spitzen Winkel mit der Lüfterachse A bzw. einer Ebene ein, die die Lüfterachse A beinhaltet. Die vorderen Leitflächen 11 zumindest eines Teils der Leitschaufeln 9, 10 sollten in dieser Form ausgebildet sein bzw. zumindest bereichsweise einen spitzen Winkel mit der Lüfterachse A bzw. einer Ebene, die die Lüfterachse A beinhaltet, einschließen, sodass der Luftstrom vom Axiallüfter 1 kommend möglichst parallel zur Lüfterachse A umgelenkt wird.

Die hinteren Leitflächen 13 eines Teils der Leitschaufeln 9 sind im Querschnitt betrachtet konvex gewölbt. Die konvex gewölbten hinteren Leitflächen 9 können hierbei zumindest annähernd parallel zu einer konkav gewölbten vorderen Leitfläche 11, 12 der benachbarten Leitschaufeln 9, 10 ausgebildet sein, sodass eine effiziente Umlenkung der Luftströmung ohne erhöhten Gegendruck zwischen zwei Leitschaufeln 9, 10 erzielt wird.

Das Luftleitelement 2 weist um die Lüfterachse A zwei Sektoren 15 auf, die mit Leitschaufeln 9, 10 besetzt sind. Zwei weitere Sektoren 16 um die Lüfterachse A sind frei von Leitschaufeln. Die mit Leitschaufeln 9, 10 besetzten Sektoren 15 gehen, bezogen auf radial äußere Enden der Leitschaufeln 9, 10, von einem Anfangsradius 17 aus, wobei der Anfangsradius 17 rechtwinklig zur Lüfterachse A verläuft. Der Anfangsradius 17 ist parallel zu den Kühlrippen 4 angeordnet. Alternativ kann der Anfangsradius 17 auch einen spitzen Winkel mit den Kühlrippen 4 einschließen. Die mit Leitschaufeln 9, 10 besetzten Sektoren 15 erstrecken sich in Drehrichtung P des Lüfterrades 6 über einen Winkel von weniger als 180 Grad, im vorliegenden gezeigten Ausführungsbeispiel von ungefähr 90 Grad.

Wie insbesondere in Figur 6 zu erkennen ist, ist die in Drehrichtung P des Lüfterrades 6 hinterste Leitschaufel 10 im Querschnitt anders ausgebildet, als die übrigen Leitschaufeln 9 desselben Sektors 15. In Richtung der Lüfterachse A betrachtet, nimmt die Dicke der Leitschaufel 10 in Hauptförderrichtung F um ein Vielfaches zu. Die hintere Leitfläche 14 schließt hierbei einen stumpfen Winkel mit einer Ebene ein, die rechtwinklig zur Lüfterachse A angeordnet ist. Die Luft strömt somit mit einem erhöhten Drall aus.

Das Luftleitelement 2 weist einen Rahmen 18 auf, innerhalb dessen die Leitschaufeln 9, 10 angeordnet sind. Der Rahmen 18 weist eine umlaufende nach innen zur Lüfterachse A weisende Innenfläche 19 auf, die einen parallel zur Lüfterachse A verlaufenden Durchgang 20 durch das Leitelement 2 derart umgrenzt, dass sich der Durchgang 20 zum Kühlkörper 3 hin im Querschnitt erweitert. Hierzu schließt die Innenfläche 19 zumindest bereichsweise einen Winkel von 40 bis 50 Grad mit einer Ebene ein, die im rechten Winkel zur Lüfterachse A angeordnet ist. Im dargestellten Ausführungsbeispiel weist der Rahmen 18 einen in etwa quadratischen Außenumfang auf, wobei in den Ecken des Rahmens 18 die Innenfläche 19 im Querschnitt kreisabschnittsförmige gestaltet ist und einen Winkel von etwa 45° mit der Ebene einschließt, die im rechten Winkel zur Lüfterachse angeordnet ist (siehe Figur 6).

Innerhalb des Rahmens 18 koaxial zur Lüfterachse A ist ein im Querschnitt kreisförmige Zentralabschnitt 21 gebildet, von dem aus die Leitschaufeln 9, 10 ausgehen, die weiter bis zum Rahmen 18 verlaufen. In dem gezeigten Ausführungsbeispiel sind die Leitschaufeln 9, 10 jedes Segments 15 derart angeordnet, dass die in Drehrichtung des Läuferrads 6 vorderen Leitschaufeln 9 im Wesentlichen, bzw. die vorderen Kanten der vorderen Leitschaufeln 9, tangential zum Zentralabschnitt 21 angeordnet sind bzw. die vorderen Kanten in Verlängerung die Lüfterachse A mit Abstand kreuzen. Die hinterste Leitschaufel 10 ist im Wesentlichen radial zur Lüfterachse A angeordnet, wobei die vordere Kante der hintersten Leitschaufel 10 radial zur Lüfterachse A angeordnet sein kann.

Der Zentralabschnitt 21 des gezeigten Ausführungsbeispiels verjüngt sich im Querschnitt in Richtung der Hauptförderrichtung F.

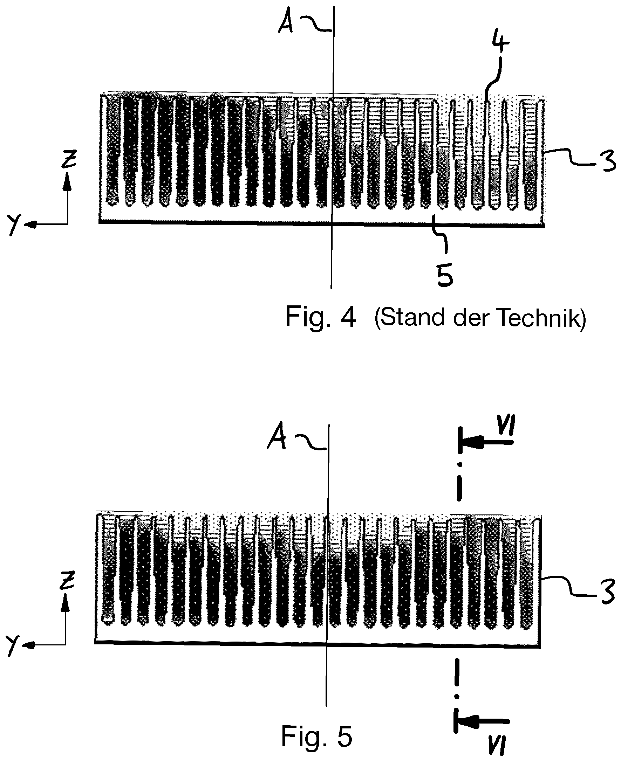

In den Figuren 4 und 5 sind die Strömungsgeschwindigkeiten der Kühlluft zwischen den Kühlrippen 4 zu erkennen. Figur 4 zeigt die Strömungsgeschwindigkeiten bei einer Vorrichtung zum Kühlen ohne den Einsatz eines Luftleitelements, wie es aus dem Stand der Technik bekannt ist. Figur 5 zeigt die Strömungsgeschwindigkeiten mit dem Einsatz eines Luftleitelements 2. Die Figuren 4 und 5 zeigen hierzu eine Seitenansicht des Kühlkörpers 3 in Richtung der X-Achse bzw. der Längsachse.

In den Figuren 4 und 5 ist das Frontprofil der einzelnen Kühlrippen 4 zu erkennen, die weiß (ohne Muster) dargestellt sind. Die Graustufen- und Mustermarkierung zwischen den Kühlrippen zeigen die Strömungsgeschwindigkeit der Luft an. Je höher die Strömungsgeschwindigkeit in den Zwischenräumen zwischen den Kühlrippen 4 ist, desto dunkler ist die Graustufenmarkierungen dargestellt. In Figur 4 ist zu erkennen, dass die Verteilung der starken Luftströmung nicht gleichmäßig über alle Zwischenräume zwischen den Kühlrippen 4 verteilt ist. Hier strömt die Luft mit hoher Geschwindigkeit nur im linken Bereich der Kühlrippenzwischenräume. In Figur 5 ist erkennbar, dass in allen Kühlrippenzwischenräume eine verhältnismäßig hohe Strömungsgeschwindigkeit der Kühlluft herrscht.

### Bezugszeichenliste

- 1: Axiallüfter
- 2: Luftleitelement
- 3: Kühlkörper
- 4: Kühlrippen
- 5: Grundplatte
- 6: Lüfterrad
- 7: Lüfterschaufel
- 8: Lüfternabe
- 9: Leitschaufel
- 10: Leitschaufel
- 11: vordere Leitfläche
- 12: vordere Leitfläche
- 13: hintere Leitfläche
- 14: hintere Leitfläche
- 15: mit Leitschaufeln besetzter Sektor
- 16: leitschaufelfreier Sektor
- 17: Anfangsradius
- 18: Rahmen
- 19: Innenfläche
- 20: Durchgang
- 21: Zentralabschnitt

- A: Lüfterachse
- F: Hauptförderrichtung
- L: Längsachse
- L1: erste Ausströmrichtung
- L2: zweite Ausströmrichtung
- P: Drehrichtung/Drall
- X: X-Achse
- Y: Y-Achse
- Z: Z Achse

## Patentansprüche

1. Vorrichtung zum Kühlen wärmeabstrahlender Bauteile umfassend einen Kühlkörper (3) mit einer Vielzahl von Kühlrippen (4), die entlang einer Längsachse (L) gerade und parallel zueinander angeordneten sind, einen Axiallüfter (1) zum Fördern von Kühlluft in einer Hauptförderrichtung (F) entlang einer Lüfterachse (A), wobei der Axiallüfter (1) auf dem Kühlkörper (3) angeordnet ist und die Lüfterachse (A) quer zur Längsachse (L) ausgerichtet ist und wobei der Axiallüfter (1) ein Lüfterrad (6) aufweist, das um die Lüfterachse (A) drehend angetrieben ist und mehrere quer zur Lüfterachse (A) verlaufende Lüfterschaufeln (7) aufweist, und
ein Luftleitelement (2), das für eine Beeinflussung der Luftströmung zwischen dem Axiallüfter (1) und dem Kühlkörper (3) angeordnet ist,
wobei das Luftleitelement (2) in zwei Sektoren (15) um die Lüfterachse (A) mit Leitschaufeln (9, 10) besetzt ist und in zwei weiteren Sektoren (16) um die Lüfterachse (A) frei von Leitschaufeln ist, und
wobei die mit Leitschaufeln (9, 10) besetzten Sektoren (15) jeweils, auf radial äußere Enden der Leitschaufeln (9, 10) bezogen, von einem Anfangsradius (17) bezogen auf die Lüfterachse (A) ausgehen, der einen spitzen Winkel mit den Kühlrippen (4) einschließt oder parallel zu den Kühlrippen (4) angeordnet ist, und in Drehrichtung des Lüfterrades (6) über einen Winkel von weniger als 180 Grad verlaufen.

2. Vorrichtung nach Anspruch 1,
**dadurch gekennzeichnet,**
**dass** das Luftleitelement (2) mehrere quer zur Lüfterachse (A) verlaufende Leitschaufeln (9, 10) aufweist.

3. Vorrichtung nach Anspruch 2,
**dadurch gekennzeichnet,**
**dass** die Leitschaufeln (9, 10) jeweils, in Drehrichtung des Lüfterrades (6) betrachtet, eine Leitschaufelvorderseite mit einer vorderen Leitfläche (11, 12) und eine Leitschaufelrückseite mit einer hinteren Leitfläche (13, 14) aufweisen.

4. Vorrichtung nach Anspruch 3,
**dadurch gekennzeichnet,**
**dass** die vordere Leitfläche (11, 12) zumindest einer der Leitschaufeln (9, 10) konkav gewölbt ausgebildet ist.

5. Vorrichtung nach Anspruch 3 oder 4,
**dadurch gekennzeichnet,**
**dass** die vordere Leitfläche (11, 12) zumindest einer der Leitschaufeln (9, 10) zumindest bereichsweise einen spitzen Winkel mit einer Ebene einschließt, die die Lüfterachse (A) beinhalten.

6. Vorrichtung nach einem der Ansprüche 3 bis 4,
**dadurch gekennzeichnet,**
**dass** die hintere Leitfläche (13) zumindest einer der Leitschaufeln (9) konvex gewölbt ausgebildet ist.

7. Vorrichtung nach einem der Ansprüche 3 bis 6,
**dadurch gekennzeichnet,**
**dass** die hintere Leitfläche (14) zumindest einer der Leitschaufeln (10) zumindest bereichsweise einen stumpfen Winkel mit einer Ebene einschließt, die rechtwinklig zur Lüfterachse (A) angeordnet ist.

8. Vorrichtung nach einem der Ansprüche 1 bis 7,
**dadurch gekennzeichnet,**
**dass** sich die mit Leitschaufeln (9, 10) besetzten Sektoren (15) jeweils über einen Winkel von 80 Grad bis 100 Grad erstrecken.

9. Vorrichtung nach einem der Ansprüche 1 bis 8,
**dadurch gekennzeichnet,**
**dass** sich die Dicke zumindest der in Drehrichtung (P) des Lüfterrades (6) betrachtet hintersten Leitschaufel (10) eines Sektors in Hauptförderrichtung (F) um ein Vielfaches vergrößert.

10. Vorrichtung nach einem der Ansprüche 3 bis 9,
**dadurch gekennzeichnet,**
**dass** alle Leitschaufeln (9, 10) derart angeordnet sind, dass deren vorderen Leitflächen (11, 12) jeweils zumindest eine der Kühlrippen (4) queren.

11. Vorrichtung nach einem der Ansprüche 1 bis 10,
**dadurch gekennzeichnet,**
**dass** der Axiallüfter (1) und das Luftleitelement (2) in Richtung der Lüfterachse (A) deckungsgleiche Außenkonturen aufweisen.

12. Vorrichtung nach einem der Ansprüche 1 bis 11,
**dadurch gekennzeichnet,**
**dass** das Luftleitelement (2) einen Rahmen (18) aufweist, innerhalb dessen die Leitschaufeln (9, 10) angeordnet sind, und
**dass** der Rahmen (18) nach innen zur Lüfterachse (A) weisende Innenflächen (19) aufweist, die zumindest bereichsweise einen Winkel von 40 bis 50 Grad zu einer Ebene aufweisen, die im rechten Winkel zur Lüfterachse (A) angeordnet ist.

## Claims

1. Device for cooling heat radiating components comprising
a cooling body (3) having a plurality of cooling fins (4) arranged straight and parallel to each other along a longitudinal axis (L),
an axial fan (1) for conveying cooling air in a main conveying direction (F) along a fan axis (A), the axial fan (1) being arranged on the cooling body (3) and the fan axis (A) being arranged transversely to the longitudinal axis (L), and the axial fan (1) having a fan propeller (6) which is driven in rotation about the fan axis (A) and has a plurality of fan blades (7) arranged transversely to the fan axis (A), and
an air guiding element (2) arranged between the axial fan (1) and the cooling body (3) for influencing the air flow,
wherein the air guiding element (2) is set with guiding vanes (9, 10) in two sectors (15) around the fan axis (A) and is free of guiding vanes in two further sectors (16) around the fan axis (A), and
wherein the sectors (15) set with guiding vanes (9, 10) each start, with respect to radially outer ends of the guiding vanes (9, 10), from an initial radius (17) with respect to the fan axis (A) which encloses an acute angle with the cooling fins (4) or is arranged parallel to the cooling fins (4), and extend over an angle of less than 180 degrees in the direction of rotation of the fan propeller (6).

2. Device according to claim 1,
**characterized in**
**that** the air guiding element (2) has a plurality of guiding vanes (9, 10) arranged transversely to the fan axis (A).

3. Device according to claim 2,
**characterized in**
**that** the guiding vanes (9, 10) each have, viewed in the direction of rotation of the fan propeller (6), a guiding vane front side with a front guiding surface (11, 12) and a guiding vane rear side with a rear guiding surface (13, 14).

4. Device according to claim 3,
**characterized in**
**that** the front guiding surface (11, 12) of at least one of the guiding vanes (9, 10) is concavely curved.

5. Device according to claim 3 or 4,
**characterized in**
**that** the front guiding surface (11, 12) of at least one of the guiding vanes (9, 10) encloses, at least in some portions, an acute angle with a plane containing the fan axis (A).

6. Device according to any one of claims 3 to 4,
**characterized in**
**that** the rear guiding surface (13) of at least one of the guiding vanes (9) is convexly curved.

7. Device according to any one of claims 3 to 6,
**characterized in**
**that** the rear guiding surface (14) of at least one of the guiding vanes (10) encloses, at least in some portions, an obtuse angle with a plane which is perpendicular to the fan axis (A).

8. Device according to any one of claims 1 to 7,
**characterized in**
**that** the sectors (15) set with guiding vanes (9, 10) each extend over an angle of 80 degrees to 100 degrees.

9. Device according to any one of claims 1 to 8,
**characterized in**
**that** the thickness of at least the rearmost guiding vane (10) of a sector, as viewed in the direction of rotation (P) of the fan propeller (6), increases by a multiple in the main conveying direction (F).

10. Device according to any one of claims 3 to 9,
**characterized in**
**that** all guiding vanes (9, 10) are arranged in such a way that their front guiding surfaces (11, 12) each cross at least one of the cooling fins (4).

11. Device according to any one of claims 1 to 10,
**characterized in**
**that** the axial fan (1) and the air guiding element (2) have congruent outer contours in the direction of the fan axis (A).

12. Device according to any one of claims 1 to 11,
**characterized in**
**that** the air guiding element (2) has a frame (18) within which the guiding vanes (9, 10) are arranged, and
**that** the frame (18) has inner surfaces (19) facing inwards towards the fan axis (A), which inner surfaces (19), at least in some portions, have an angle of 40 to 50 degrees to a plane which is arranged perpendicular to the fan axis (A).

## Revendications

1. Dispositif, destiné à refroidir des composants rayonnant de la chaleur, comprenant
un dissipateur thermique (3) pourvu d'une pluralité d'ailettes de refroidissement (4), qui le long d'un axe longitudinal (L) sont disposées en ligne droite et à la parallèle les unes des autres,
un ventilateur (1) axial, destiné à convoyer de l'air de refroidissement dans une direction de convoyage (F) principale le long d'un axe (A) de ventilateur, le ventilateur (1) étant disposé en direction axiale sur le dissipateur thermique (3) et l'axe (A) de ventilateur étant orienté à la transversale de l'axe longitudinal (L) et le ventilateur (1) comportant en direction axiale une roue de ventilation (6), qui est entraînée en rotation autour de l'axe (A) de ventilateur et qui comporte plusieurs pales (7) de ventilateur s'écoulant à la transversale de l'axe (A) de ventilateur, et
un élément de guidage d'air (2), qui pour influencer l'écoulement d'air est disposé entre le ventilateur (1) axial et le dissipateur thermique (3),
l'élément de guidage d'air (2) étant occupé par des pales directrices (9, 10) dans deux secteurs (15) autour de l'axe (A) de ventilateur et dans deux autres secteurs (16) autour de l'axe (A) de ventilateur, étant exempt de pales directrices, et
chaque fois en rapport à des extrémités extérieures en direction radiale des pales directrices (9, 10), les secteurs (15) occupés par des pales directrices (9, 10) partant d'un rayon initial (17) par rapport à l'axe (A) de ventilateur qui forme un angle aigu avec les ailettes de refroidissement (4) ou qui est placé à la parallèle des ailettes de refroidissement (4) et dans la direction de rotation des roues de ventilation (6), s'écoulant sur un angle de moins de 180 degrés.

2. Dispositif selon la revendication 1,
**caractérisé**
**en ce que** l'élément de guidage d'air (2) comporte plusieurs pales directrices (9, 10) s'écoulant à la transversale de l'axe (A) de ventilateur.

3. Dispositif selon la revendication 2,
**caractérisé**
**en ce que** considérées dans la direction de rotation de la roue de ventilation (6), les pales directrices (9, 10) comportent une face avant de pale directrice, dotée d'une surface de guidage (11, 12) avant et une face arrière de pale directrice, dotée d'une surface de guidage (13, 14) arrière.

4. Dispositif selon la revendication 3,
**caractérisé**
**en ce que** la surface de guidage (11, 12) avant d'au moins l'une des pales directrices (9, 10) est conçue avec une voussure concave.

5. Dispositif selon la revendication 3 ou 4, **caractérisé**
**en ce que** la surface de guidage (11, 12) avant d'au moins l'une des pales directrices (9, 10) forme au moins par endroits un angle aigu avec un plan qui contient l'axe (A) de ventilateur.

6. Dispositif selon l'une quelconque des revendications 3 à 4,
**caractérisé**
**en ce que** la surface de guidage (13) arrière d'au moins l'une des pales directrices (9) est conçue avec une voussure convexe.

7. Dispositif selon l'une quelconque des revendications 3 à 6,
**caractérisé**
**en ce que** la surface de guidage (14) arrière d'au moins l'une des pales directrices (10) forme au moins par endroits un angle obtus avec un plan qui est disposé à angle droit par rapport à l'axe (A) de ventilateur.

8. Dispositif selon l'une quelconque des revendications 1 à 7,
**caractérisé**
**en ce que** les secteurs (15) occupés par les pales directrices (9, 10) s'étendent respectivement sur un angle de 80 degrés à 100 degrés.

9. Dispositif selon l'une quelconque des revendications 1 à 8,
**caractérisé**
**en ce que** l'épaisseur d'au moins la pale directrice (10) la plus à l'arrière d'un secteur, considérée dans la direction de rotation (P) de la roue de ventilation s'agrandit d'un multiple dans la direction de convoyage (F) principale.

10. Dispositif selon l'une quelconque des revendications 3 à 9,
**caractérisé**
**en ce que** toutes les pales directrices (9, 10) sont disposées de telle sorte que leurs surfaces de guidage (11, 12) avant croisent respectivement au moins l'une des ailettes de refroidissement (4).

11. Dispositif selon l'une quelconque des revendications 1 à 10,
**caractérisé**
**en ce que** le ventilateur (1) comporte en direction axiale et l'élément de guidage d'air (2) comporte en direction de l'axe (A) de ventilateur des contours coïncidents.

12. Dispositif selon l'une quelconque des revendications 1 à 11,
**caractérisé**
**en ce que** l'élément de guidage d'air (2) comporte un cadre (18), à l'intérieur duquel sont disposées les pales directrices (9, 10), et
**en ce que** le cadre (18) comporte des surfaces intérieures (19) dirigées vers l'intérieur, en direction de l'axe (A) de ventilateur, qui au moins par endroits, forment un angle de 40 à 50 degrés avec un plan qui est disposé à angle droit par rapport à l'axe (A) de ventilateur.
